# EUROPEAN PATENT SPECIFICATION

(11) **EP 1 507 835 B1**
(45) Date of publication and mention of the grant of the patent: **08.02.2006**
(21) Application number: 02700637.8
(22) Date of filing: 20.02.2002
(51) Int. Cl.: C09J 7/02

(54) **SEALING MATERIAL FOR ELECTRICAL/ELECTRONIC APPLIANCE**
DICHTUNGSMATERIAL FÜR ELEKTRISCHE UND ELEKTRONISCHE GERÄTE
MATERIAU D'ETANCHEIFICATION DESTINE A UN APPAREIL ELECTRIQUE/ELECTRONIQUE

(30) Priority: 13.04.2001 JP 2001115071
(43) Date of publication of application: 23.02.2005
(73) Proprietor: NITTO DENKO CORPORATION, Ibaraki-shi, Osaka 567-0041 (JP)
(72) Inventor: TACHIBANA, Katsuhiko, Nitto Denko Corporation, Ibaraki-shi, Osaka 567-0041 (JP)
(74) Representative: Ward, David Ian
(86) International application number: PCT/JP2002/001494
(87) International publication number: WO 2002/084918

(56) References cited:
- EP-A- 1 008 637
- EP-A- 1 059 327
- WO-A-86/03767
- PATENT ABSTRACTS OF JAPAN vol. 2000, no. 13, 5 February 2001 (2001-02-05) & JP 2000 303059 A (NITTO DENKO CORP), 31 October 2000 (2000-10-31)

## Description

### Technical Field

The present invention relates to a shaped sealing material for electrical/electronic appliances (portable telephones, portable terminals, digital cameras, video movies, personal computers, other domestic electrical appliances, and the like).

### Background Art

Rubber foams have excellent cushioning properties and are useful as cushioning materials, padding materials, and the like. For example, rubber foams are used as dust-preventive cushioning materials for the liquid crystal displays, plasma displays, organic EL displays, and the like of electrical/electronic appliances such as portable telephones and digital cameras. Sealing materials having a pressure-sensitive adhesive layer are frequently used especially in order to facilitate the positioning of such displays during bonding operations. However, there are cases where use of the conventional sealing materials having a pressure-sensitive adhesive layer poses a problem that the pressure-sensitive adhesive protrudes from an edge of the sealing material and dust particles adhere thereto, resulting in problems in the product such as appearance failures and a decrease in function.

JP2000303059A describes a water stop member capable of being easily repositioned, rarely undergoing mis-positioning such as twist or slide, having excellent applicability because of easy fit into between members, and providing persistent high- performance water seal of excellent reliability.

EP1059327A discloses a heat-resistant polymer foam which has an average cell diameter of from 0.01 µm to less than 10 µm. This heat-resistant polymer foam can be produced by, for example, impregnating a heat-resistant polymer under pressure with an non-reactive gas such as carbon dioxide, which is in, e.g., a supercritical state, reducing the pressure, and then heating the polymer at a temperature exceeding 120 DEG C to foam the polymer.

Known techniques for eliminating this problem are to partly form a pressure-sensitive adhesive layer, thereby preventing the protrusion of the pressure-sensitive adhesive layer from an edge of the sealing material, or to use a sealing material without forming a pressure-sensitive adhesive layer thereon. However, the former technique imposes a heavy burden on the processing cost, leading to a cost increase. The latter technique has a problem that the sealing material is difficult to fix in position or newly necessitates a method for position fixing.

Further, with the recent trend toward size reduction in electrical/electronic appliances, the sealing materials for use in these applications have also come to be required to have a reduced width and reduced thickness. Because of this requirement, the sealing materials themselves have come to have poor shape retention, resulting in a problem concerning handleability.

Under these circumstances, an object of the invention is to provide a shaped sealing material for electrical/electronic appliances, which is free from dust particle adhesion thereto and is easy to handle although it is a sealing material comprising a foam and a pressure-sensitive adhesive layer formed thereon.

### Disclosure of the Invention

As a result of intensive investigations to accomplish the object, it has been found that a sealing material which comprises a finely cellular foam and formed on a surface thereof a layer of a pressure-sensitive adhesive composition having a storage modulus of 20 N/cm² or higher and which has an adhesive force of 5.0 N/20 mm width or higher can be easily processed so as to have a small width and a small thickness, can be reduced in dust particle adhesion to edges thereof because of the non-tackiness of the pressure-sensitive adhesive, and can, after application, be fixed due to the adhesive force of the pressure-sensitive adhesive.

It has been further found that such a finely cellular foam is obtained by impregnating a specific polymer with an inert gas at high pressure and then reducing the pressure.

The invention has been completed based on those findings.

The invention relates to a sealing material for electrical/electronic appliances, comprising a foamed structure having an average cell diameter of 0.1 to 500 µm and, formed on at least one side thereof, a layer comprising a pressure-sensitive adhesive composition having a storage modulus as measured at room temperature (G') of 20 N/cm² or higher, the sealing material having an adhesive force of 5.0 N/20 mm width or higher.

The term "storage modulus (G') of a pressure-sensitive adhesive composition" as used herein means a shear storage modulus of the composition, and should be regarded as a property indicating elastic components which store an external stress as a strain energy. Values of this property are obtained by using a sample having a thickness of about 1.5 mm and a diameter of 7.9 mm and a parallel plate jig (diameter: 7.9 mm), and measuring the same with dynamic viscoelastometer RDS-II, manufactured by Rheometrics, Inc., at a frequency of 1 Hz.

The term "adhesive force of a sealing material" as used herein means 90° peeling adhesive force determined by adhering a sample to an acrylic plate (poly(methyl methacrylate)) as an adherend and examining the sample under the conditions of an ambient temperature of 23°C, an adhesion period of 30 minutes, and a peeling rate of 300 mm/min.

The term "adhesive force of a pressure-sensitive adhesive composition" as used herein means 180° peeling adhesive force determined by applying the pressure-sensitive adhesive composition to a poly(ethylene terephthalate) film having a thickness of 25 µm, drying the resulting coating to form a pressure-sensitive adhesive layer having a thickness of 30 µm, adhering this coating film as a sample to an acrylic plate (poly(methyl methacrylate)), and examining the sample under the conditions of an ambient temperature of 23°C, an adhesion period of 30 minutes, and a peeling rate of 300 mm/min.

### Brief Description of the Drawing

The Figure is a schematic view showing one use example of the sealing material for electrical/electronic appliances of the invention.

### [Description of Reference Numerals]

1: sealing material for electrical/electronic appliances
   11: foamed structure
   12: pressure-sensitive adhesive layer
   13: pressure-sensitive adhesive layer
2: liquid crystal display
3: outer frame portion

### Mode for Carrying Out the Invention

The foamed structure used in the invention is not particularly limited in composition as long as it is a foamed structure having an average cell diameter of 10 to 500 µm. Conventional foams having a closed cell structure, an open cell structure, or a semi-closed and semi-open cell structure can be used. By regulating the average cell diameter to 500 µm or smaller, preferably 300 µm or smaller, more preferably 200 µm or smaller, the shape retention property of the foamed structure is secured, so that the foamed structure, even when narrow and thin, canbeeasilyprocessed. Further, by regulating the average cell diameter to 10 µm or larger, cushioning properties can be imparted.

For forming such a foam having cells in inner parts thereof, physical foaming and chemical foaming are generally conducted. The physical foaming is a technique in which a polymer is impregnated with a hydrocarbon type or chlorofluorocarbon type low-boiling liquid and then heated to thereby gasify the low-boiling liquid infiltrated therein and foam the polymer by utilizing the gas as a driving force. The chemical foaming is a technique in which a resin composition obtained by adding a heat-decomposable foaming agent to a polymer is heated to thereby form cells by the action of the gas formed by the decomposition of the decomposable foaming agent.

Production of such a foamed structure can use the following methods: a method comprising kneading natural rubber or a synthetic rubber (chloroprene rubber, ethylene/propylene terpolymer, or the like) with a kneading machine such as a Banbury mixer or pressure kneader, together with a vulcanizing agent, a foaming agent, a filler and the like, molding the resultingmixture into a sheet form or rod form while continuously kneading it with a calender or an extruder or by conveyor belt casting or the like, heating the resulting molding to vulcanize and foam the rubber, and cutting the vulcanized foam into a given shape according to need; and a method comprising kneading natural rubber or a synthetic rubber with mixing rolls together with a vulcanizing agent, a foaming agent, a filler, and the like, and vulcanizing, foaming and molding this kneaded composition in a mold batchwise.

The method for obtaining the foamed structure of the invention is to impregnate a specific polymer with an inert gas at high pressure and then reduce the pressure. The reasons for this are as follows. The technique of physical foaming has fears concerning combustibility and toxicity of substances used as a foaming agent and influences thereof on the environment, such as ozonosphere depletion. The technique of chemical foaming has the problem that since a residue of the foaming gas remains in the foam, use of the foam in electronic appliances where fouling inhibition is highly required poses a problem concerning fouling by a corrosive gas or by impurities contained in the gas. Incidentally, in each of these techniques for physical foaming and chemical foaming, it is difficult to form a finely cellular structure. In particular, these techniques are regarded as incapable of forming fine cells of 300 µm or smaller.

The foamed structure having an average cell diameter of 10 to 500 µm in the invention is formed by a method in which the foam is formed through the steps of impregnating a thermoplastic polymer with a high pressure inert gas and then reducing the pressure, or by a method in which the foam is formed through the steps of impregnating an unfoamed molding comprising a thermoplastic polymer with a high pressure inert gas and then reducing the pressure, or by a method in which the foam is formed by impregnating a molten thermoplastic polymer with an inert gas under pressure and then molding the impregnated polymer while reducing the pressure.

The thermoplastic polymer used in the invention as a material for the foam is not particularly limited as long as it is a polymer having thermoplasticity and can be impregnated with a high pressure gas. Examples of such thermoplastic polymers include olefin polymers such as low-density polyethylene, medium-density polyethylene, high-density polyethylene, linear low-density polyethylene, polypropylene, copolymers of ethylene with propylene, copolymers of ethylene or propylene with other α-olefin (s), and copolymers of ethylene with vinyl acetate, acrylic acid, an acrylic ester, methacrylic acid, a methacrylic ester, vinyl alcohol, etc. ; styrene polymers such as polystyrene; polyamides; poly(amide-imide)s; polyurethanes; polyimides; polyetherimides; and the like.

The thermoplastic polymer further includes a thermoplastic elastomer which shows rubbery properties at ordinary temperature and shows thermoplasticity at high temperatures. Examples of such thermoplastic elastomers include olefin elastomers such as ethylene/propylene copolymers, ethylene/propylene/diene copolymers, ethylene/vinyl acetate copolymers, polybutene, polyisobutylene, and chlorinated polyethylene; styrene elastomers such as styrene/butadiene/styrene copolymers, styrene/isoprene/styrene copolymers, styrene/isoprene/butadiene/styrene copolymers, and polymers obtained by hydrogenating these copolymers; thermoplastic polyester elastomers; thermoplastic polyurethane elastomers; and thermoplastic acrylic elastomers. Since these thermoplastic elastomers have a glass transition temperature of room temperature or lower (e.g., 20°C or lower), they give a sealing material highly excellent in flexibility and the ability to conform to various shapes.

Thermoplastic polymers can be used alone or as a mixture of two or more thereof. Further, any of a thermoplastic elastomer, a thermoplastic polymer other than thermoplastic elastomers, and a mixture of a thermoplastic elastomer with a thermoplastic polymer other than thermoplastic elastomers can be used as a material (thermoplastic polymer) for the foam.

Examples of the mixture of a thermoplastic elastomer with a thermoplastic polymer other than thermoplastic elastomers include mixtures of an olefin elastomer such as an ethylene/propylene copolymer with an olefin polymer such as polypropylene, and the like. In the case of using a mixture of a thermoplastic elastomer with a thermoplastic polymer other than thermoplastic elastomers, these are mixed in such a proportion that the former/latter ratio is, for example, about 1/99 to 99/1 (preferably about 10/90 to 90/10, more preferably about 20/80 to 80/20).

The inert gas used in the invention is not particularly limited as long as it is inert to the thermoplastic polymer and is capable of infiltrating into the polymer. Examples of the inert gas include carbon dioxide, nitrogen gas, air, and the like. These gases may be used as a mixture. Preferred of these is carbon dioxide because it can be infiltrated in a large amount and at a high rate into the thermoplastic polymer used as a material for the foam.

The inert gas with which a thermoplastic polymer is impregnated is preferably in a supercritical state. When in a supercritical state, a gas has enhanced solubility in the polymer and can be infiltrated in high concentration. Upon an abrupt pressure drop after the impregnation, cell nuclei generate in a larger amount because of the high concentration as described above. These cell nuclei grow into cells, the density of which is higher than in foams having the same porosity. Consequently, fine cells can be obtained. Incidentally, carbon dioxide has a critical temperature of 31°C and a critical pressure of 7.4 MPa.

In forming the foam, one or more additives may be added to the thermoplastic polymer according to need. The additives are not particularly limited in kind, and various additives for general use in foam molding can be used. Examples of such additives include nucleating agents for cells, nucleating agents for crystals, plasticizers, lubricants, colorants, ultraviolet absorbers, antioxidants, fillers, reinforcements, flame retardants, antistatic agents, and the like. The amount of additives added can be suitably selected as long as the additives do not impair cell formation, etc., and an addition amount used in the molding of ordinary thermoplastic polymers including thermoplastic elastomers can be employed.

The foam is produced through a gas impregnation step in which a thermoplastic polymer is impregnated with an inert gas at high pressure and a pressure reduction step in which after the gas impregnation step the pressure is reduced to foam the resin, and optionally through a heating step in which the cells are grown by heating. In this case, an unfoamed molding which has been molded beforehand may be impregnated with an inert gas. Alternatively, a molten thermoplastic polymer may be impregnated with an inert gas under pressure and then molded while reducing the pressure. These steps may be conducted either batchwise or continuously.

In a batch process, a foam can be formed, for example, in the following manner. First, a thermoplastic polymer such as a polyolefin resin or thermoplastic elastomer is extruded with an extruder such as a single-screw extruder or twin-screw extruder to thereby form an unfoamed molding (e.g., a resin sheet for foam molding). Alternatively, a thermoplastic polymer such as a polyolefin resin or thermoplastic elastomer is evenly kneaded beforehand with rollers, a cam, a kneader, or a kneading machine having Banbury type blades and this resin is press-molded with a hot-plate pressing machine to form an unfoamed molding (e.g., a resin sheet for foam molding) comprising the thermoplastic polymer as a base resin. The unfoamed molding obtained is placed in a pressure vessel, and a high-pressure inert gas is introduced thereinto to infiltrate the inert gas into the unfoamed molding. In this case, the shape of the unfoamed molding is not particularly limited and may be any of a roll form, a plate form, and the like. The introduction of a high-pressure inert gas may be conducted continuously or discontinuously. At the time when the high-pressure inert gas has been sufficiently infiltrated, the molding is released from the pressure (usually, the pressure is reduced to the atmospheric pressure) to thereby generate cell nuclei in the base resin. The cell nuclei may be merely allowed to grow at room temperature, or may be grown by heating according to need. For heating, known or common techniques may be employed, such as heating with a water batch, oil bath, heated roll, hot-air oven, far infrared rays, near infrared rays, microwave, or the like. After the cells are thus grown, the foam is rapidly cooled with, e.g., cold water to fix the shape.

In a continuous process, on the other hand, a foam can be formed, for example, in the following manner. A thermoplastic polymer is kneaded with an extruder such as a single-screw extruder or twin-screw extruder and, simultaneously therewith, a high-pressure inert gas is forced into the extruder to sufficiently infiltrate the gas into the thermoplastic polymer. The polymer is extruded to release it from the pressure (usually, the pressure is reduced to the atmospheric pressure) and is foamed and molded simultaneously. In some cases, the cells are grown by heating. After the cells are grown, the foam is rapidly cooled with, e.g., cold water to fix the shape.

In the gas impregnation step, the pressure is, for example, 6 MPa or higher (e.g. , about 6 to 100 MPa), preferably 8 MPa or higher (e.g., about 8 to 100 MPa). In case where the pressure is lower than 6 MPa, cell growth during foaming proceeds excessively, so that the cell diameter becomes too large and this tends to result in a decrease in soundproofing effect. The reason for this is as follows. When the pressure is low, the amount of the gas infiltrated is relatively small as compared with the case of high-pressure impregnation and the rate of the formation of cell nuclei is low, resulting in a smaller number of cell nuclei. Consequently, the amount of the gas per cell increases, rather then decreases, and the cell diameter hence increases exceedingly. Furthermore, in the range of pressures lower than 6 MPa, only a slight change in impregnation pressure results in a considerable change in cell diameter and cell density. Because of this, such low pressures tend to result in difficulties in regulating the cell diameter and cell density.

The temperature in the gas impregnation step varies depending on the kinds of the inert gas and thermoplastic polymer used, etc., and can be selected from a wide range. However, in view of operating efficiency and others, the temperature is, for example, about 10 to 350°C. For example, in the case where an unfoamed molding in a sheet or another form is impregnated with an inert gas, the impregnation temperature in a batch process is about 10 to 200°C, preferably about 40 to 200°C. In the case where a molten polymer impregnated with a gas is extruded to simultaneously conduct foaming and molding, the impregnation temperature in a continuous process is generally about 60 to 350°C. Incidentally, when carbon dioxide is used as the inert gas, the temperature during impregnation is preferably 32°C or higher, more preferably 40°C or higher, so as to maintain a supercritical state.

In the pressure reduction step, the rate of pressure reduction is not particularly limited. However, it is preferably about 5 to 300 MPa/sec so as to obtain uniform fine cells. In the heating step, the heating temperature is, for example, about 40 to 250°C, preferably about 60 to 250°C.

The foamed structure in the invention has excellent flexibility because the foam is made of a thermoplastic polymer, e.g., a thermoplastic elastomer. In addition, due to the use of an inert gas, e.g., carbon dioxide, as a foaming agent, the foamed structure is clean and neither generates a harmful substance nor contains a fouling substance remaining therein, unlike the foamed structures obtained by physical foaming techniques and chemical foaming techniques used hitherto. Because of this, the foamed structure is suitable for use as a shaped sealing material especially in inner parts of electrical/electronic precision appliances and the like.

The shaped sealing material for electrical/electronic appliances of the invention comprises the foamed structure and, formed on at least one side thereof, a layer comprising a pressure-sensitive adhesive composition having a storage modulus as measured at room temperature (G') of 20 N/cm² or higher, and has an adhesive force of 5.0 N/20-mm width or higher.

The pressure-sensitive adhesive composition used in the invention has been regulated so as to have a storage modulus as measured at room temperature (G') of 20 N/cm² or higher, preferably 50 N/cm² or higher (usually 500 N/cm² or lower). The pressure-sensitive adhesive composition, which has such properties, has no tackiness and is inhibited from protruding after processing. Dust particles are hence less apt to adhere thereto. Further, in about several seconds after application, the sealing material using the adhesive composition can be peeled without damaging the adherend. Consequently, the sealing material has the characteristic that positioning and positional correction are easy (so-called reworking suitability).

Since the shaped sealing material for electrical/electronic appliances of the invention has been regulated so as to have-an adhesive force of 5.0 N/20 mm width or higher, preferably 10.0 N/20 mm width or higher, more preferably 15 N/20 mm width or higher (usually 30.0 N/20 mm width or lower), it has such a unique and useful property that it exhibits high bonding strength without necessitating a complicated step such as heat treatment. Adhesive forces lower than 5.0 N/20 mm width are undesirable in that the sealing material readily peels off the adherend.

In order for the pressure-sensitive adhesive composition for use in the invention to have such pressure-sensitive adhesive properties, it is regulated so as to have a storage modulus as measured at room temperature (G') of 20 N/cm² or higher, preferably 50 N/cm² or higher (usually 500 N/cm² or lower), and an adhesive force as measured at room temperature of 5.0 N/20 mm width or higher, preferably 10.0 N/20 mm width or higher (usually 30.0 N/20 mm width or lower) . This pressure-sensitive adhesive composition is preferably used as an outermost layer.

The pressure-sensitive adhesive composition having such properties is not particularly limited in composition as long as it has the above-described storage modulus (G') and adhesive force. In general, a preferred composition is one prepared by adding a crosslinking agent such as a polyisocyanate compound to a polymer for pressure-sensitive adhesive constitution to crosslink the polymer so that the storage modulus (G') and adhesive force thereof are regulated to the above-described values based on the selection of the polymer, degree of crosslinking, etc. Preferred examples of the polymer for pressure-sensitive adhesive constitution include polymers having a polycarbonate structure, i.e., polymers comprising repeating units represented by the following formula: 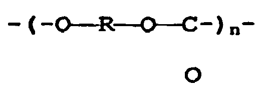
wherein R is a linear or branched hydrocarbon group having 2 to 20 carbon atoms. In particular, a polyester synthesized from a polycarbonate diol and a dibasic acid is preferably used. A polyester having a glass transition temperature (loss modulus: G" peak) of -35°C or lower is also preferably used. Further, acrylic polymers and the like can be used besides such aliphatic polyesters.

Examples of the polymers having a polycarbonate structure include polyesters synthesized from a polycarbonate diol (or a derivative thereof) and a dicarboxylic acid (or a derivative thereof), polyesters synthesized from a polycarbonatedicarboxylic acid and a diol, polyurethanes synthesized from a polycarbonate diol and a diisocyanate, and the like. Of those, polyesters synthesized from a polycarbonate diol and a dicarboxylic acid are particularly preferable. This kind of polyester is synthesized from a diol component comprising a polycarbonate diol as an essential component and a dicarboxylic acid component comprising as an essential component a dicarboxylic acid having an aliphatic or alicyclic hydrocarbon group having 2 to 20 carbon atoms as the molecular skeleton, and has a weight average molecular weight of 10,000 or higher, preferably 30,000 or higher, more preferably 50,000 or higher (usually up to 300,000).

The polycarbonate diol used is a diol having repeating units represented by the following formula: 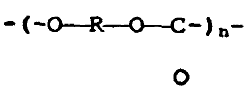
wherein R is a linear or branched hydrocarbon group having 2 to 20 carbon atoms, and preferably having a number average molecular weight of 400 or higher, preferably 900 or higher (usually up to 10,000). Examples of such polycarbonate diols include poly(hexamethylene carbonate) diol, poly(3-methylpentene carbonate) diol, poly (propylene carbonate) diol, and the like, mixture or copolymers of these, and the like. Examples of commercial products include "PLACCEL CD205PL", "PLACCEL CD208PL", "PLACCEL CD210PL", "PLACCEL CD220PL", "PLACCEL CD205HL", "PLACCEL CD208HL", "PLACCEL CD210HL", and "PLACCELCD220HL", all manufactured by Dicel Chemical Industries, Ltd., etc.

The diol component may further contain, besides the polycarbonate diol described above, an component such as a linear diol or a branched diol, e.g., ethylene glycol, propylene glycol, butanediol, hexanediol, octanediol, decanediol, or octadecanediol, according to need. Such optional diols are preferably used in an amount of 50% by weight or smaller, preferably 30% by weight or smaller, based on the weight of the whole diol components. For the purpose of obtaining a polymer having a higher molecular weight, a polyol component having a functionality of 3 or higher may be added in a small amount.

The dicarboxylic acid component is one comprising an aliphatic or alicyclic hydrocarbon group having 2 to 20 carbon atoms as the molecular skeleton. The hydrocarbon group may be linear or branched. Examples the dicarboxylic acid component include succinic acid, methylsuccinic acid, adipic acid, pimelic acid, azelaic acid, sebacic acid, 1,12-dodecanedioic acid, 1,14-tetradecanedioic acid, tetrahydrophthalic acid, endomethylenetetrahydrophthalic acid, anhydrides and lower alkyl esters of these acids, and the like.

The dicarboxylic acid component desirably consists only of one or more of those dicarboxylic acids comprising an aliphatic or alicyclic hydrocarbon group having 2 to 20 carbon atoms as the molecular skeleton. In some cases, however, those dicarboxylic acids may be suitably used as a mixture with one or more dicarboxylic acids comprising an aromatic hydrocarbon group as the molecular skeleton. Those dicarboxylic acids comprising an aromatic hydrocarbon group as the molecular skeleton may be used preferably in an amount as small as up to 50% by weight, more preferably up to 30% by weight, based on the weight of the whole dicarboxylic acid components. For the purpose of synthesizing a polyester having a higher molecular weight or for other purposes, a polycarboxylic acid component having a functionality of 3 or higher may be added in a small amount.

A polyester is obtained by subjecting the diol component and dicarboxylic acid component to an esterification reaction in a conventional manner without a catalyst or using an appropriate catalyst. Although it is desirable to react the diol component and the dicarboxylic acid component in an equimolar proportion, one of these may be used in excess in order to accelerate the esterification reaction. The polyester thus obtained desirably has the above-described molecular weight. The reasons for this are as follows. When a polyester having too low a molecular weight is used, a highly crosslinked pressure-sensitive adhesive obtained therefrom has too high a crosslink density and is exceedingly hard. Conversely, when a low crosslink density is to be obtained, the crosslinked polymer is unsatisfactory in heat resistance, etc., because of the low molecular weight of the uncrosslinked component.

In the invention, a polymer having a polycarbonate structure, including such a polyester, is usually crosslinked by an ordinary technique to give a pressure-sensitive adhesive composition having room temperature storage modulus (G') and adhesive force within the above-described ranges. Any desired technique for crosslinking may be used. However, a general method comprises reacting a polyfunctional compound such as a polyisocyanate compound, epoxy compound, aziridine compound, metal chelate compound or metal alkoxide compound, as a crosslinking agent with the polymer (hydroxyl groups or carboxyl groups contained therein) to crosslink the polymer. Especially preferred polyfunctional compound is a polyisocyanate compound.

Examples of the polyisocyanate compound include lower aliphatic polyisocyanates such as ethylene diisocyanate, butylene diisocyanate and hexamethylene diisocyanate, alicyclic polyisocyanates such as cyclopentylene diisocyanate, cyclohexylene diisocyanate and isophorone diisocyanate, aromatic polyisocyanates such as 2,4-tolylene diisocyanate, 4,4'-diphenylmethane diisocyanate and xylylene diisocyanate, and the like. Also usable besides these are a tolylene diisocyanate adduct of trimethylolpropane ("Coronate L" manufactured by Nippon Polyurethane Co., Ltd.) and a hexamethylene diisocyanate adduct of trimethylolpropane ("Coronate HL" manufactured by Nippon Polyurethane Co., Ltd.).

Those polyfunctional compounds may be used alone or as a mixture of two or more thereof. The amount of a polyfunctional compound used is appropriately selected according to a balance between the compound and the polymer to be crosslinked and according to the intended use of the pressure-sensitive adhesive composition. In general, a polyfunctional compound may be incorporated in an amount of 0.5 parts by weight or larger, preferably about 1 to 5 parts by weight, per 100 parts by weight of a polymer having a polycarbonate structure to crosslink it. Thus, a pressure-sensitive adhesive composition is obtained in which the polymer has a solvent-insoluble content of 10 to 90% by weight, preferably 15 to 80% by weight, more preferably 20 to 70% by weight. In case where the polymer has too low a solvent-insoluble content, the pressure-sensitive adhesive has insufficient cohesive force, so that a sufficient modulus of elasticity, sufficient heat resistance or sufficient durability cannot be obtained.

Another technique for crosslinking is to incorporate a polyfunctional monomer as a crosslinking agent into a polymer and crosslink this polymer with electron beams or the like. Examples of the polyfunctional monomer include ethylene glycol di(meth)acrylate, pentaerythritol tri(meth)acrylate, tetramethylolmethane tetra(meth)acrylate, trimethylolpropane tri(meth)acrylate and the like. The amount of these polyfunctional monomers is desirably 1 to 5 parts by weight, preferably 2 to 4 parts by weight, per 100 parts by weight of the polymer so that the polymer after crosslinking with electron beams or the like has the same solvent-insoluble content as described above.

Various conventional tackifiers may be incorporated into the pressure-sensitive adhesive composition in the invention. The incorporation of a tackifier may facilitate a balance between pressure-sensitive adhesive properties and heat resistance. Various conventional additives, e.g., powdery, particulate or flaky substances, such as inorganic or organic fillers, metal powders and pigments, can also be incorporated in a desired manner. Furthermore, various antioxidants may be incorporated so as to further improve durability.

The layer of the pressure-sensitive adhesive composition is formed in a thickness of usually 2 to 100 µm, preferably 10 to 100 µm. The smaller the thickness of these pressure-sensitive adhesive layers, the better. This is because smaller thicknesses are more effective in preventing the adhesion of dust particles to edges. The pressure-sensitive adhesive layer can be formed by a direct coating method or a method in which the layer is formed on a release paper and is then applied to the foamed structure. Besides being formed on one side of a foamed structure, the layer comprising the pressure-sensitive adhesive composition may be formed on both sides thereof. Prior to the formation of the layer comprising the pressure-sensitive adhesive composition, another pressure-sensitive adhesive layer or a base may be formed, as an underlying layer, on the surface of the foamed structure. Namely, a multilayered coating may be formed in this or another manner.

In the case where the layer of the pressure-sensitive adhesive composition is formed on only one side of the foamed structure, a pressure-sensitive adhesive layer having a composition different from that of the above-described pressure-sensitive adhesive composition described above,e.g., general-purpose acrylic pressure-sensitive adhesive layers or rubber-based pressure-sensitive adhesive layers, may be formed on the opposite side of the foamed structure. In this case, not only positioning can be easily conducted due to the layer of the tack-free pressure-sensitive adhesive composition described above formed on one side, but also features of the general-purpose pressure-sensitive adhesive layer formed on the other side can also be exhibited.

The sealing material for electrical/electronic appliances of the invention is not particularly limited in shape, and may be suitably subjected to a processing, e.g., cutting or punching, according to the intended use thereof.

Embodiments of the sealing material for electrical/electronic appliances of the invention will be explained below based on the drawing. However, the invention should not be construed as being limited to those embodiments in any way.

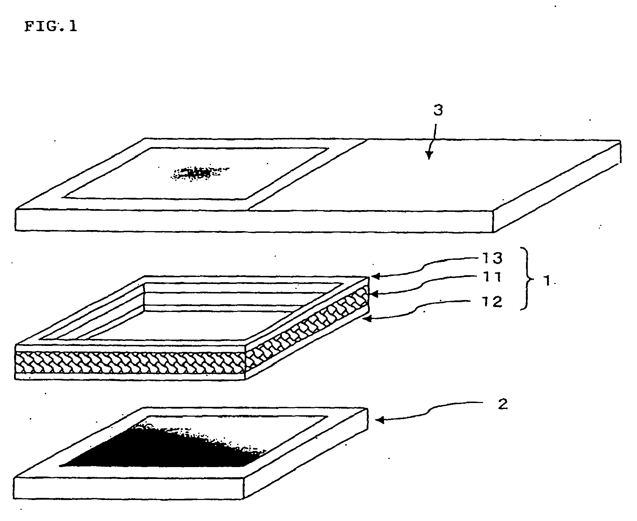

Fig. 1 schematically shows an example of uses of the sealing material for electrical/electronic appliances of the invention. In Fig. 1, 1 denotes an architrave-form sealing material punched from a sealing material for electrical/electronic appliances of the invention. The structure shown comprises a foamed structure 11 and pressure-sensitive adhesive layers 12 and 13 formed on both sides thereof. Numerals 2 and 3 denote a liquid crystal display and an outer frame portion, respectively.

The sealing material for electrical/electronic appliances 1 is fixed (provisionally fixed) to the liquid crystal display 2 with a pressure-sensitive adhesive layer 12 so that the sealing material 1 is located along the periphery of the display 2. In this operation, the sealing material for electrical/electronic appliances 1 shows good workability because it has stiffness and good shape retention due to the small average cell diameter thereof. The pressure-sensitive adhesive layer 12 has a room temperature storage modulus of 20 N/cm² or higher and does not have high tackiness of pressure-sensitive adhesives. Consequently, the pressure-sensitive adhesive layer 12 hardly adheres in a short period of time of about several seconds. Because of this, the sealing material 1 can be stripped off in a short period of time after application and then used again. The position in which the sealing material 1 has been applied can be corrected without damaging the adherend.

The pressure-sensitive adhesive layer 12 has an adhesive force of 5 N/20 mm width or higher although it has a high modulus and is tack-free as described above. Consequently, it has such a unique and useful property that it exhibits high bonding strength without necessitating a complicated step such as heat treatment. Due to this property, the sealing material for electrical/electronic appliances 1 does not peel off the liquid crystal display 2 before the subsequent step.

The liquid crystal display 2 to which the sealing material for electrical/electronic appliances 1 has been fixed is fixed to the outer frame portion 3 through a pressure-sensitive adhesive layer 13. In this operation, the sealing material 1 is fixed in a moderately pressed state. As a result, the sealing material for electrical/electronic appliances 1, which has cushioning properties, functions to buffer impacts and to seal for protection against dust, water, etc.

### Industrial Applicability

Since the sealing material for electrical/electronic appliances of the invention has been regulated so as to have an average cell diameter of 500 µm or smaller, the shape retention of the foamed structure is secured. Even when the foamed structure is narrow and thin, it can be easyprocessed. Moreover, since the pressure-sensitive adhesive has been regulated so as to have a storage modulus of 20 N/cm² or higher and an adhesive force of 5.0 N/20 mm width or higher, not only the adhesion of dust particles to edges of the sealing material can be diminished, but also the pressure-sensitive adhesive, after application, can exhibit its adhesive force to fix the sealing material.

Further, the foam has excellent flexibility because it is made of a thermoplastic polymer, e.g., a thermoplastic elastomer. Since an inert gas, e.g., carbon dioxide, is used as a foaming agent, the foamed structure is clean and neither generates a harmful substance nor contains a fouling substance remaining therein, unlike the foams obtained by physical foaming techniques and chemical foaming techniques used hitherto. Because of this, the sealing material of the invention is especially suitable for use as a sealing material for liquid crystal displays or the like used in electrical/electronic appliances such as portable telephones and video cameras.

### Examples

The invention will be explained below in detail by reference to Examples, but the invention should not be construed as being limited by those Examples in any way. Unless otherwise indicated, all parts are by weight.

### EXAMPLE 1

50 Parts of polypropylene having a density of 0. 9 g/cm³ and a melt flow rate at 230°C of 4 was kneaded with a kneading machine having roller type blades (trade name "Labo Plastomill" manufactured by Toyo Seiki Seisaku-Sho, Ltd.) at a temperature of 170°C together with 50 parts of an ethylene/propylene elastomer having a JIS-Ahardness of 69 and 100 parts of polyhedral MgO·ZnO·H₂O (average particle diameter, 1.0 µm; aspect ratio, 4). The resulting composition was molded into a sheet form having a thickness of 0.5 mm and a diameter of 80 mm with a hot platen press heated to 180°C.

This sheet was placed in a pressure vessel and maintained in a 150°C atmosphere at an elevated pressure of 15 MPa/cm² for 10 minutes to thereby impregnate it with carbon dioxide. After 10 minutes, the pressure was abruptly reduced to thereby obtain a foamed structure having an average cell diameter of 100 µm. This foamed structure was sliced into a thickness of 1 mm.

On the other hand, 250 g of a liquid polycarbonate diol ("PLACCEL CD210PL" manufactured by Dicel Chemical Industries, Ltd.; hydroxyl value, 115 KOH-mg/g) (hydroxyl groups: 0.512 equivalents), 51.8 g of sebacic acid (acid groups: 0.512 equivalents), and 127 mg of dibutyltin oxide (hereinafter referred to as "DBTO") as a catalyst were introduced into a four-necked separable flask equipped with a stirrer, thermometer, and water separation tube. In the presence of a small amount of toluene as a solvent for reaction water discharge, stirring was initiated and the contents were heated to 180°C with stirring and maintained at this temperature. After a while, reaction began to proceed and water effusion was observed. The reaction was continued for about 24 hours. As a result, a polyester having a weight average molecular weight of 55,000 was obtained.

This polyester was diluted with toluene to a solid concentration of 40% by weight. Thereto was added 2 parts (on a solid basis) of a hexamethylene diisocyanate trimer adduct of trimethylolpropane ("Coronate HL" manufactured by Nippon Polyurethane Co., Ltd.) as a crosslinking agent per 100 parts (on a solid basis) of the polyester. Thus, a pressure-sensitive adhesive composition was prepared.

The pressure-sensitive adhesive composition thus prepared was applied with an applicator to one side of the foamed structure obtained above. The resulting coating was dried at 130°C for 5 minutes to form a layer of the pressure-sensitive adhesive composition having a thickness of 30 µm. Thus, a sealing material of the invention was produced.

A sample for adhesive force measurement for the pressure-sensitive adhesive was produced by applying the pressure-sensitive adhesive composition to a PET film having a thickness of 25 µm with an applicator, drying the resulting coating at 130°C for 5 minutes to form a pressure-sensitive adhesive layer having a thickness of 30 µm, and aging the coated film in a 50°C atmosphere for 5 days to conduct postcure. In the same manner as described above, the pressure-sensitive adhesive composition was applied to a release paper to form a pressure-sensitive adhesive layer having a thickness of 50 µm to be subjected to storage modulus measurement.

### EXAMPLE 2

250 g of a liquid polycarbonate diol ["PLACCEL CD220PL" manufactured by Dicel Chemical Industries, Ltd.; hydroxyl value, 56.1 KOH-mg/g] (hydroxyl groups: 0.25 equivalents), 23.5 g of azelaic acid (acid groups: 0.25 equivalents), and 62 mg of DBTO as a catalyst were introduced into a four-necked separable flask equipped with a stirrer, thermometer, and water separation tube. In the presence of a small amount of toluene as a solvent for reaction water discharge, stirring was initiated and the contents were heated to 180°C with stirring and maintained at this temperature. After a while, a reaction began to proceed and water effusion was observed. The reaction was continued for about 25 hours. As a result, a polyester having a weight average molecular weight of 78,000 was obtained.

This polyester was diluted with toluene to a solid concentration of 40% by weight. Thereto was added 1.5 parts (on a solid basis) of a tolylene diisocyanate trimer adduct of trimethylolpropane ("Coronate L" manufactured by Nippon Polyurethane Co., Ltd.) as a crosslinking agent per 100 parts (on a solid basis) of the polyester. Thus, a pressure-sensitive adhesive composition was prepared. A sealing material of the invention was produced in the same manner as in Example 1, except that this pressure-sensitive adhesive composition was used.

A tape sample for adhesive force measurement and a pressure-sensitive adhesive layer for storage modulus measurement were formed in the same manners as in Example 1.

### COMPARATIVE EXAMPLE 1

95 Parts of n-butyl acrylate, 5 parts of acrylic acid, 150 parts of toluene, and 0.1 part of azobisisobutyronitrile were introduced into a reactor equipped with a stirrer and a thermometer. Solution polymerization was conducted in a nitrogen gas atmosphere at 60°C for about 7 hours to obtain a polymer solution. 2 Parts (on a solid basis) of a tolylene diisocyanate trimer adduct of trimethylolpropane ["Coronate L" manufactured by Nippon Polyurethane Co., Ltd.] as a crosslinking agent per 100 parts (on a solid basis) of the polyester were added to the polymer solution. Thus, a pressure-sensitive adhesive composition was prepared. A sealing material was produced in the same manner as in Example 1, except that this pressure-sensitive adhesive composition was used.

A tape sample for adhesive force measurement and a pressure-sensitive adhesive layer for storage modulus measurement were formed in the same manners as in Example 1.

### COMPARATIVE EXAMPLE 2

The composition shown below was kneaded with mixing rolls. The composition kneaded was heated in an oven under the conditions of 160°C and 30 minutes to vulcanize and foam it and then taken out of the oven. Thus, a foamed structure having an average cell diameter of 800 µm was obtained.

### Composition for Foamed Structure

| | |
|---|---|
| Ethylene/propylene terpolymer | 100 parts |
| Zinc white | 5 parts |
| Stearic acid | 1 part |
| Carbon | 40 parts |
| Polyethylene | 20 parts |
| Heavy calcium carbonate | 180 parts |
| Polybutene | 40 parts |
| Sulfur | 2 parts |
| Mercaptobenzothiazole | 1 part |
| Zinc diethyl dithiocarbamate | 2 parts |
| Azodicarboxamide | 13 parts |

A sealing material was obtained in the same manner as in Example 1, except that this foamed structure was used.

The pressure-sensitive adhesive layers formed for storage modulus measurement in the Examples and Comparative Examples given above were examined for storage modulus. Further, the tape samples for adhesive force measurement and the sealing materials were examined for adhesive force. The sealing materials were further examined for dust adhesion and suitability for processing/working (handleability). The results obtained are shown in the Table below.

### Storage Modulus:

Storage modulus was measured with dynamic viscoelastometer RDS-II, manufactured by Rheometrics, Inc., at a frequency of 1 Hz using a sample having a thickness of about 1.5 mm an a diameter of 7.9 mm and a parallel-plate jig having a diameter of 7.9 mm.

### Adhesive Force of Pressure-Sensitive Adhesive:

The tape sample for adhesive force measurement obtained was cut into a size having a length of 150 mm and a width of 20 mm. The cut strip was applied to an acrylic plate (poly (methyl methacrylate)) by rolling a rubber roller having a weight of 2 kg forward and backward once. The resulting test piece was allowed to stand at 23°C for 30 minutes and then examined with a tensile tester in an atmosphere of 23°C and 65% RH at a peeling angle of 180°C and a peeling rate of 300 m/min.

### Adhesive Force of Sealing Material:

The sealing material obtained was cut into a size having a length of 150 mm and a width of 20 mm. The cut strip was applied to an acrylic plate (poly(methyl methacrylate)) by rolling a rubber roller having a weight of 2 kg forward and backward once. The resulting test piece was allowed to stand at 23°C for 30 minutes and then examined with a tensile tester in an atmosphere of 23°C and 65% RH at a peeling angle of 90°C and a peeling rate of 300 m/min.

### Dust Adhesion:

The sealing material sample obtained was allowed to stand at room temperature for 1 week, and the degree of the adhesion of dust particles to the edges of the adhesive was visually examined. The samples to which almost no dust particles had adhered are rated as "○" and those to which considerable dust particles had adhered are rated as "×".

### Processability:

The sealing material sample obtained was cut into an architrave-form sample having a thickness of 1 mm, a width of 2 mm, and a side length of 50 mm. This sample was evaluated as to whether the attachment thereof to a given position was easy or difficult. The samples which could be easily handled are rated as "○" and those which had poor processability and were difficult to handle are rated as "×".

**Table**

| | Example 1 | Example 2 | Comparative Example 1 | Comparative Example 2 |
|---|---|---|---|---|
| Storage modulus [N/cm²] | 71 | 96 | 11 | 71 |
| Adhesive force of sealing material [N/20 mm] | 22.5 | 25.0 | 12.5 | 23.3 |
| Adhesive force of pressure-sensitive adhesive [N/20 mm] | 9.6 | 12.5 | 8.0 | 9.6 |
| Dust adhesion | ○ | ○ | × | ○ |
| Processability | ○ | ○ | ○ | × |

As apparent from the results shown in the above Table, the shaped sealing materials obtained in the Examples of the invention each are reduced in the adhesion of dust particles because the layer of a pressure-sensitive adhesive composition formed on the foamed structure shows no tackiness at room temperature. In addition, since the layer has high adhesive force, the sealing material can be fixed. The results further show that since the foamed structure has a small average cell diameter, each of the sealing materials can retain its shape even when processed so as to be thin and narrow, and can be easily applied (handled).

In contrast, the sealing material of ComparativeExample 1, which comprises a foamed structure and formed thereon a pressure-sensitive adhesive layer having properties different from those in the invention, undergoes considerabledust adhesion because the pressure-sensitive adhesive layer has tackiness at room temperature. This sealing material hence has poor performances when used as a sealing material for electrical/electronic appliances. The sealing material of Comparative Example 2 has poor processability when thin and narrow, because the foamed structure has poor stiffness due to its large average cell diameter.

## Claims

1. A sealing material for electrical/electronic appliances, comprising a foamed structure having an average cell diameter of from 10 to 500 µm formed through the steps of impregnating a thermoplastic polymer with a high pressure inert gas and then reducing the pressure and, formed on at least one side thereof, a layer comprising a pressure-sensitive adhesive composition having a storage modulus as measured at room temperature (G') of 20 N/cm² or higher, the sealing material having an adhesive force of 5.0 N/20 mm width or higher.

2. The sealing material for electrical/electronic appliances as claimed in claim 1, wherein the layer comprising a pressure-sensitive adhesive composition having a storage modulus as measured at room temperature (G') of 20 N/cm² or higher and an adhesive force as measured at room temperature of 5.0 N/20 mm width or higher is provided on an outermost surface of the sealing material.

3. The sealing material for electrical/electronic appliances as claimed in claim 1, wherein the layer comprising a pressure-sensitive adhesive composition has a thickness of 2 to 100 µm.

4. The sealing material for electrical/electronic appliances as claimed in claim 1, wherein the pressure-sensitive adhesive composition contains a polymer having a polycarbonate structure comprising repeating units represented by the following formula: 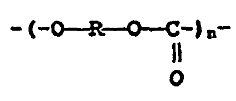
wherein R is a linear or branched hydrocarbon group having 2 to 20 carbon atoms.

5. The sealing material for electrical/electronic appliances as claimed in claim 1, wherein the inert gas is carbon dioxide.

6. The sealing material for electrical/electronic appliances as claimed in claim 1, wherein the inert gas is in a supercritical state during the impregnation.

7. The sealing material for electrical/electronic appliances as claimed in claim 1, wherein the thermoplastic polymer is a molten thermoplastic polymer.

8. The sealing material for electrical/electronic appliances as claimed in claim 1, wherein the formation of the foamed structure further comprises a step of heating after pressure reduction.

9. The sealing material for electrical/electronic appliances as claimed in claim 1, wherein the foamed structure has an average cell diameter of from 10 to 300 µm.

10. The sealing material for electrical/electronic appliances as claimed in claim 1, wherein the foamed structure has an average cell diameter of from 10 to 200 µm.

11. The sealing material for electrical/electronic appliances as claimed in claim 1, wherein the pressure-sensitive adhesive composition has a storage modulus as measured at room temperature (G') of 50 N/cm² or higher.

12. The sealing material for electrical/electronic appliances as claimed in claim 1, which has an adhesive force of 10 N/20 mm width or higher.

13. The sealing material for electrical/electronic appliances as claimed in claim 1, which has an adhesive force of 15 N/20 mm width or higher.

14. The sealing material for electrical/electronic appliances as claimed in claim 1, wherein the pressure-sensitive adhesive composition has a storage modulus as measured at room temperature (G') of 50 N/cm² or higher and an adhesive force of 10 N/20 mm width or higher.

15. An electrical/electronic appliance having a display, **characterised in that** the device incorporates the sealing material of claim 1 to seal around the display.

## Revendications

1. Matériau d'étanchéification destiné à des appareils électriques/électroniques, comprenant une structure moussée ayant un diamètre moyen des cellules allant de 10 à 500 µm, formé par les étapes d'imprégnation d'un polymère thermoplastique avec un gaz inerte sous haute pression, puis réduction de la pression et, formée sur au moins une face de celle-ci, une couche comprenant une composition adhésive sensible à la pression, ayant un module de stockage mesuré à température ambiante (G') de 20 N/cm² ou plus, le matériau d'étanchéification ayant une force adhésive de 5.0 N/20 mm de largeur ou plus.

2. Matériau d'étanchéification destiné à des appareils électriques/électroniques selon la revendication 1, dans lequel la couche comprenant une composition adhésive sensible à la pression, ayant un module de stockage mesuré à température ambiante (G') de 20 N/cm² ou plus, et ayant une force adhésive mesurée à température ambiante de 5,0 N/20 mm de largeur ou plus, est disposée sur la surface la plus extérieure du matériau d'étanchéification.

3. Matériau d'étanchéification destiné à des appareils électriques/électroniques selon la revendication 1, dans lequel la couche comprenant une composition adhésive sensible à la pression a une épaisseur de 2 à 100 µm.

4. Matériau d'étanchéification destiné à des appareils électriques/électroniques selon la revendication 1, dans lequel la composition adhésive sensible à la pression contient un polymère ayant une structure de polycarbonate, comprenant les unités récurrentes représentées par la formule suivante :
-(O-R-O-C(=O)-)ₙ
où R est un groupe hydrocarbure linéaire ou ramifié, ayant 2 à 20 atomes de carbone.

5. Matériau d'étanchéification destiné à des appareils électriques/électroniques selon la revendication 1, dans lequel le gaz inerte est du dioxyde de carbone.

6. Matériau d'étanchéification destiné à des appareils électriques/électroniques selon la revendication 1, dans lequel dans lequel le gaz inerte est à l'état supercritique pendant l'imprégnation.

7. Matériau d'étanchéification destiné à des appareils électriques/électroniques selon la revendication 1, dans lequel le polymère thermoplastique est un polymère thermoplastique fondu.

8. Matériau d'étanchéification destiné à des appareils électriques/électroniques selon la revendication 1, dans lequel la formation de la structure moussée comprend en outre, l'étape de chauffage après réduction de la pression.

9. Matériau d'étanchéification destiné à des appareils électriques/électroniques selon la revendication 1, dans lequel la structure moussée a un diamètre moyen des cellules allant de 10 à 300 µm.

10. Matériau d'étanchéification destiné à des appareils électriques/électroniques selon la revendication 1, dans lequel la structure moussée a un diamètre moyen des cellules allant de 10 à 200 µm.

11. Matériau d'étanchéification destiné à des appareils électriques/électroniques selon la revendication 1, dans lequel la composition adhésive sensible à la pression a un module au stockage mesuré à température ambiante (G') de 50 N/cm² ou plus.

12. Matériau d'étanchéification destiné à des appareils électriques/électroniques selon la revendication 1, qui a une force adhésive de 10 N/20 mm de largeur ou plus.

13. Matériau d'étanchéification destiné à des appareils électriques/électroniques selon la revendication 1, qui a une force adhésive de 15 N/20 mm de largeur ou plus.

14. Matériau d'étanchéification destiné à des appareils électriques/électroniques selon la revendication 1, dans lequel la composition adhésive sensible à la pression a un module au stockage mesuré à température ambiante (G') de 50 N/cm² ou plus et une force adhésive de 10 N/20 mm de largeur ou plus.

15. Appareil électrique/électronique ayant un affichage, **caractérisé en ce que** le dispositif comprend le matériau d'étanchéification de la revendication 1 pour le scellement autour de l'affichage.

## Patentansprüche

1. Dichtungsmaterial für elektrische/elektronische Vorrichtungen, umfassend:
eine Schaumstoffstruktur mit einem mittleren Zellendurchmesser von 10 bis 500 µm, die mit den folgenden Schritten ausgebildet ist: Imprägnieren eines thermoplastischen Polymers mit einem inerten Gas unter hohem Druck und anschließendes Reduzieren des Drucks; und
eine auf mindestens einer Seite derselben ausgebildete Schicht, die eine Haftklebermischung mit einem bei Zimmertemperatur gemessenen Speichermodul (G') von 20 N/cm² oder mehr umfasst, wobei das Dichtungsmaterial eine Haftkraft von 5,0 N / 20 mm Breite oder mehr hat.

2. Dichtungsmaterial für elektrische/elektronische Vorrichtungen nach Anspruch 1, wobei die Schicht, die eine Haftklebermischung mit einem bei Zimmertemperatur gemessenen Speichermodul (G') von 20 N/cm² oder mehr und einer bei Zimmertemperatur gemessenen Haftkraft von 5,0 N / 20 mm Breite oder mehr umfasst, auf einer Außenfläche des Dichtungsmaterials ausgebildet ist.

3. Dichtungsmaterial für elektrische/elektronische Vorrichtungen nach Anspruch 1, wobei die Schicht, die eine Haftklebermischung umfasst, eine Dicke von 2 bis 100 µm hat.

4. Dichtungsmaterial für elektrische/elektronische Vorrichtungen nach Anspruch 1, wobei die druckempfindliche Haftklebermischung ein Polymer mit einer Polycarbonatstruktur mit sich wiederholenden Einheiten enthält, die durch die folgende Formel dargestellt sind: 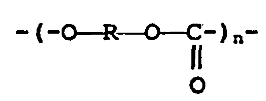
wobei R eine lineare oder verzweigte Kohlenwasserstoffgruppe mit 2 bis 20 Kohlenstoffatomen ist.

5. Dichtungsmaterial für elektrische/elektronische Vorrichtungen nach Anspruch 1, wobei das inerte Gas Kohlendioxid ist.

6. Dichtungsmaterial für elektrische/elektronische Vorrichtungen nach Anspruch 1, wobei das inerte Gas während der Imprägnierung in überkritischem Zustand ist.

7. Dichtungsmaterial für elektrische/elektronische Vorrichtungen nach Anspruch 1, wobei das thermoplastische Polymer ein geschmolzenes thermoplastisches Polymer ist.

8. Dichtungsmaterial für elektrische/elektronische Vorrichtungen nach Anspruch 1, wobei die Ausbildung der Schaumstoffstruktur ferner einen Schritt des Erwärmen nach Druckreduzierung umfasst.

9. Dichtungsmaterial für elektrische/elektronische Vorrichtungen nach Anspruch 1, wobei die Schaumstoffstruktur einen mittleren Zellendurchmesser von 10 bis 300 µm hat.

10. Dichtungsmaterial für elektrische/elektronische Vorrichtungen nach Anspruch 1, wobei die Schaumstoffstruktur einen mittleren Zellendurchmesser von 10 bis 200 µm hat.

11. Dichtungsmaterial für elektrische/elektronische Vorrichtungen nach Anspruch 1, wobei die druckempfindliche Haftklebermischung einen bei Zimmertemperatur gemessenen Speichermodul (G') von 50 N/cm² oder mehr hat.

12. Dichtungsmaterial für elektrische/elektronische Vorrichtungen nach Anspruch 1, das eine Haftkraft von 10 N / 20 mm Breite oder mehr hat.

13. Dichtungsmaterial für elektrische/elektronische Vorrichtungen nach Anspruch 1, das eine Haftkraft von 15 N / 20 mm Breite oder mehr hat.

14. Dichtungsmaterial für elektrische/elektronische Vorrichtungen nach Anspruch 1, wobei die Haftklebermischung einen bei Zimmertemperatur gemessenen Speichermodul (G') von 50 N/cm² oder mehr und eine Haftkraft von 10 N / 20 mm Breite oder mehr hat.

15. Elektrische/elektronische Vorrichtung mit einer Anzeige, **dadurch gekennzeichnet, daß** die Vorrichtung das Dichtungsmaterial nach Anspruch 1 einschließt, um die Anzeige ringsum abzudichten.
